# EUROPÄISCHE PATENTSCHRIFT

(11) **EP 1 074 851 B1**
(45) Veröffentlichungstag und Bekanntmachung des Hinweises auf die Patenterteilung: **27.10.2004**
(21) Anmeldenummer: 00116801.2
(22) Anmeldetag: 03.08.2000
(51) Int. Cl.: G01R 31/36, H02J 7/00

(54) **Anordnung zur Überwachung einer aus mehreren in Reihe geschalteten Batterieuntereinheiten bestehenden Batterie**
Arrangement for monitoring a battery consisting of a plurality of sub-units connected in series
Dispositif de surveillance d'une batterie constituée de plusieurs sous-unités reliées en série

(30) Priorität: 04.08.1999 DE 29913613 U
(43) Veröffentlichungstag der Anmeldung: 07.02.2001
(73) Patentinhaber: Framatome ANP GmbH, 91058 Erlangen (DE)
(72) Erfinder: Michel, Wolfgang, 91056 Erlangen (DE); Waber, Peter, 91325 Adelsdorf (DE)
(74) Vertreter: Tergau & Pohl Patentanwälte

(56) Entgegenhaltungen:
- EP-A- 0 508 030
- WO-A-93/19508
- WO-A-98/58271
- WO-A-99/26330
- "METHOD FOR DYNAMIC TEST OF A BATTERY BACKUP IN A SYSTEM ENVIRONMENT" IBM TECHNICAL DISCLOSURE BULLETIN,US,IBM CORP. NEW YORK, Bd. 36, Nr. 11, 1. November 1993 (1993-11-01), Seiten 465-466, XP000424915 ISSN: 0018-8689

## Beschreibung

Die Erfindung betrifft eine Anordnung zur Überwachung einer aus mehreren in Reihe geschalteten Batterieuntereinheiten bestehenden Batterie.

Aus der EP 0 790 690 A2 ist eine Anordnung zur Überwachung einer aus mehreren in Reihe geschalteten Blockbatterien bestehenden Batterie bekannt, die Bestandteil einer unterbrechungsfreien Stromversorgung ist. Eine Messeinrichtung erfasst über mehrere Messkanäle die Spannungen an jeder einzelnen Blockbatterie und verarbeitet diese im Rahmen eines Batterie-Management-Systems, mit dem die Batterie geladen und überwacht wird. Bei einem Batteriekreistest durch das Batterie-Management-System werden automatisch Fehler im Batteriesystem festgestellt und lokalisiert. Durch eine gezielte Teilentladung mit einem konstanten Strom und die Messung aller Blockspannungen können Fehler, wie die Erhöhung des inneren Widerstandes einzelner Blockbatterien, sowie schlechte Polverbinder oder offene Batterieschalter sowohl detektiert als auch lokalisiert werden. Die Werte für die inneren Widerstände der Blockbatterien werden in einem Permanentspeicher protokolliert. Weiterhin beobachtet das Batterie-Management-System die alterungsbedingte Abnahme der entnehmbaren Ladung mit Hilfe des Verlaufs der Blockspannung während der Teilentladung. Aufgrund der Entwicklung dieses Wertes kann dem Bediener die Durchführung einer Konditionierung zum Ausgleich reversibler Alterungserscheinungen empfohlen werden. Auch vorgeschädigte Batterieblöcke werden durch Messung von Innenwiderstand und entnehmbarer Ladung bereits bei der Inbetriebnahme erkannt.

Aus der US-A-5 218 288 ist eine Anordnung zur Überwachung einer aus mehreren Batteriezellen bestehenden Batterie bekannt, die über einen steuerbaren Gleichrichter an einer Stromversorgung und über einen steuerbaren Wechselrichter an einem Verbraucher angeschlossen ist. Eine Messeinrichtung erfasst die Spannung an der Batterie sowie den Batteriestrom und ermittelt daraus unter anderem die Restkapazität der Batterie. Dazu wird die Batterie in einen Entladungszustand gebracht und aus dem erfassten Batteriestrom, der erfassten Batteriespannung und der bekannten Anzahl der Batteriezellen die Entladungsleistung je Batteriezelle sowie die Zellenspannung berechnet, aus denen über einen abgespeicherten Kurvensatz die Restkapazität der Batterie ermittelt wird. Fehler oder Zustände innerhalb der Batterie, wie z. B. die Restkapazitäten der einzelnen Batteriezellen, lassen sich auf diese Weise nicht ermitteln. Wie die Batterie im Einzelnen in den für die Restkapazitätsermittlung vorgesehenen Entladezustand gebracht wird, ist der US-A-5 218 288 nicht zu entnehmen.

Aus der EP 0 433 573 A2 ist eine Anordnung zur Überwachung einer Batterie bekannt, die parallel zu einem von einem steuerbaren Ladegleichrichter gespeisten Verbraucher liegt. Eine die Spannung an der Batterie erfassende Messeinrichtung bewirkt durch eine Absenkung und nachfolgend eine Erhöhung der Ausgangsspannung des Ladegleichrichters für jeweils eine vorgegebene Zeit unterschiedliche Entlade- und Ladezustände der Batterie, wobei die dabei erfassten Spannungsverläufe mit abgespeicherten Referenzkennlinien verglichen werden. Darüber hinaus können für unterschiedliche Temperaturbereiche unterschiedliche Kennlinien abgespeichert sein, wobei dann die Messeinrichtung zusätzlich zur Batteriespannung auch die Temperatur erfasst.

Aus der EP 0 391 242 A2 ist es bekannt, die Ruhespannung der unbelasteten Batterie zu messen, um daraus auf die Säuredichte zu schließen.

Aus der WO 99/26330 ist eine Stromversorgungsanordnung bekann, die eine Stromversorgungungseinrichtung, einen Verbraucher und eine Batterie aufweist, wobei ein zwischen Verbraucher und Batterie geschaltetes Verbindungselement genutzt werden kann, um den Verbraucher von der Batterie zu isolieren oder den Verbraucher mit Energie zu versorgen und gleichzeitig ein Aufladen der Batterie zu vermeiden. Die Batterie weisen einen Strom und Spannung darstellenden Sensor auf. Der Verbraucher und die Stromversorgungseinrichtung weisen eine Ladungssteuerung auf. Der Erfindung liegt die Aufgabe zugrunde, eine umfassende Batterieüberwachung einschließlich Leerlaufmessungen an der Batterie zu ermöglichen, ohne dass dabei die Stromversorgung des an der Batterie liegenden Verbrauchers beeinträchtigt wird.

Erfindungsgemäß wird die Aufgabe durch die in Anspruch 1 angegebene Anordnung gelöst. Aufgrund des durch die Messeinrichtung steuerbaren Stellgliedes kann die Batterie von der Stromversorgungseinrichtung und dem Verbraucher getrennt werden, so dass Leerlaufmessungen an ihr möglich sind. Die steuerbare Stromversorgungseinrichtung stellt dabei weiterhin die Stromversorgung des Verbrauchers sicher.

Vorteilhafte Weiterbildungen der erfindungsgemäßen Anordnung sind in den Unteransprüchen angegeben.

Vorzugsweise ist parallel zu dem Stellglied eine Diode geschaltet, deren Durchlassrichtung mit der Richtung des Entladestroms der Batterie übereinstimmt, so dass bei der Leerlaufmessung an der Batterie im Falle eines Spannungseinbruchs oder -ausfalls bei der Stromversorgungseinrichtung unmittelbar eine Stromversorgung des Verbrauchers aus der Batterie erfolgt. Im normalen Betriebszustand ist die Ausgangsspannung der Stromversorgungseinrichtung geringfügig höher als die Batteriespannung, so dass die Diode sperrt und die Batterie sich im Leerlauf befindet.

Um eine differenzierte Beurteilung des Batteriezustandes zu ermöglichen, ist die Messeinrichtung vorzugsweise entweder zur Erfassung der Spannungen an den Batteriezellen oder bei einer aus Blockbatterien gebildeten Batterie zur Erfassung der Blockspannungen ausgebildet.

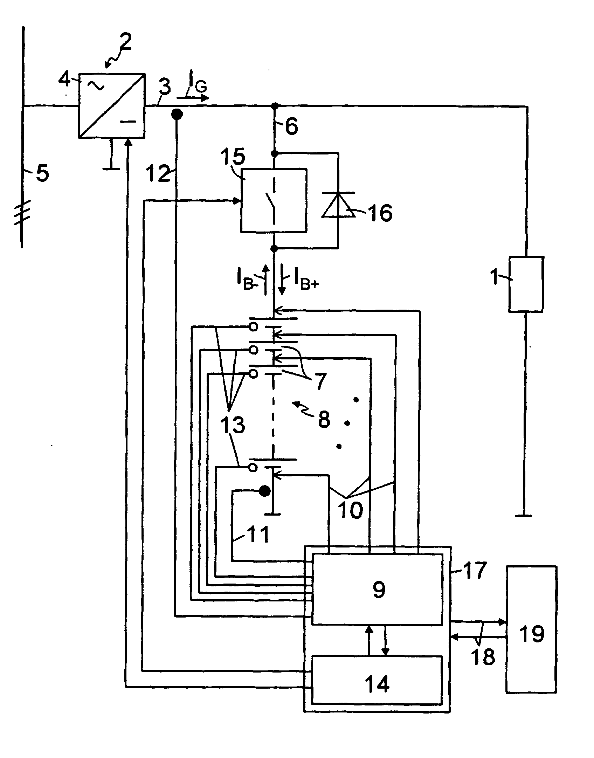

Im Weiteren wird die erfindungsgemäße Anordnung anhand eines in der Figur dargestellten Ausführungsbeispiels erläutert.

Ein Verbraucher 1 wird aus einer Stromversorgungseinrichtung 2 gespeist und liegt dazu an dem Gleichspannungsausgang 3 eines steuerbaren Gleichrichters 4, des wechselspannungsseitig an einem Wechselspannungsnetz 5 angeschlossen ist. Um eine unterbrechungsfreie Stromversorgung des Verbrauchers 1 zu gewährleisten, ist in einem parallel zu dem Verbraucher 1 liegenden Batteriezweig 6 eine aus mehreren hintereinander geschalteten Batterieuntereinheiten 7, hier Batteriezellen, bestehende Batterie 8 angeordnet. Die Batterie 8 stützt die Spannung am Verbraucher 1, wobei sie im Falle eines Spannungseinbruchs oder -ausfalls am Ausgang 3 der Stromversorgungseinrichtung 2 über den Verbraucher 1 entladen und nach Wiederherstellung der Ausgangsspannung der Stromversorgungseinrichtung 2 aus dieser wieder aufgeladen wird.

Zur Überwachung der Batterie 8 ist eine mehrkanälige Messeinrichtung 9 vorgesehen, die über Spannungsmesseingänge 10 die Spannung an jeder Batteriezelle 7 kontinuierlich erfasst. Die Messeinrichtung 9 weist ferner einen Strommesseingang 11 zur Erfassung des Batteriestromes I_{B} und einen Strommesseingang 12 zur Erfassung des Stromes I_{G} am Ausgang 3 des steuerbaren Gleichrichters 4 auf. Darüber hinaus verfügt die Messeinrichtung 9 über Temperaturmesseingänge 13 zur Erfassung der Elektrolyttemperatur in den Batteriezellen 7.

Die Messeinrichtung 9 wirkt mit einer Steuereinrichtung 14 zusammen, die zur Einstellung unterschiedlicher Betriebszustände der Batterie 8 sowohl den steuerbaren Gleichrichter 4 als auch ein Stellglied 15, z. B. ein Halbleiterschalter, hier ein Leistungsschütz, steuert, das in dem Batteriezweig 6 liegt. Parallel zu dem Stellglied 15 liegt eine Diode 16, deren Durchlassrichtung mit der Richtung des Entladestroms I_{B-} der Batterie 8 übereinstimmt.

Die Messeinrichtung 9 und die Steuereinrichtung 14 bilden eine Überwachungseinheit 17, die über eine Datenverbindung 18 mit einem übergeordneten Batterie-Management-System 19 kommuniziert. Dabei werden die erfassten Zellenspannungen in der Messeinrichtung 9 zwischengespeichert, vorverarbeitet und zur Datenübertragung komprimiert. Die Einstellung unterschiedlicher Betriebszustände der Batterie 8 zur Überwachung oder zum Aufladen der Batterie 8 wird durch das Batterie-Management-System 19 veranlasst. Innerhalb der Überwachungseinheit 17 kann erforderlichenfalls durch Lichtwellenleiterkopplung eine Potentialtrennung zwischen unterschiedlichen Signal verarbeitenden Teilen, z. B. zwischen der Messeinrichtung 9 und der Steuereinrichtung 14, oder innerhalb dieser erreicht werden. Je nach Messaufgabe können folgende unterschiedliche Betriebszustände der Batterie 8 eingestellt werden:

In einem Betriebszustand Erhaltungsladung" ist das Stellglied 15 geschlossen und es fließt aufgrund der am Ausgang 3 des Gleichrichters 4 eingestellten Ausgangsspannung ein Ladestrom I_{B+} in die Batterie 8. Von der Messeinrichtung 9 werden die Spannungen an den Batteriezellen 7 über die Zeit erfasst und ausgewertet, um evtl. schwache Batteriezellen 7 detektieren zu können, die dann mittels spezieller Starkladung aufgefrischt werden können.

In einem Betriebszustand Ruhephase" ist das Stellglied 15 geöffnet, wobei die Ausgangsspannung des Gleichrichters 4 höher ist als die Batteriespannung, so dass die Diode 16 sperrt und die Batterie 8 sich im Leerlauf befindet. Die Messeinrichtung 9 erfasst die Ruhespannung an den einzelnen Batteriezellen 7 und ermittelt daraus die Säuredichte.

In einem Betriebszustand Entladung" ist das Stellglied 15 geschlossen, wobei die Ausgangsspannung des steuerbaren Gleichrichters 4 so weit herabgesetzt ist, dass aus der Batterie 8 ein Entladestrom I_{B-} zu dem Verbraucher 1 fließt. Aus dem zeitlichen Verlauf der Spannungen an den einzelnen Batteriezellen 7 bzw. aus der Abnahme der Spannungen innerhalb einer vorgegebenen Zeitspanne ermittelt die Messeinrichtung 9 die Restkapazität der einzelnen Batteriezellen 7.

Bei einem Betriebszustand Stromsprung" ist der steuerbare Schalter 15 geschlossen, wobei der steuerbare Gleichrichter 4 derart gesteuert wird, dass die Batterie 8 mit einem sprungartigen Verlauf des Entladestroms I_{B-} belastet wird. Durch Auswertung der zeitlichen Verläufe der Spannungen an den Batteriezellen 7 ermittelt die Messeinrichtung 9 Verbindungsfehler zwischen den Batteriezellen 7 und liefert darüber hinaus eine Information über den Innenwiderstand der Batterie 8.

Die vorstehend genannten Messungen können durch die zusätzliche Erfassung des Batteriestromes I_{B} und der Elektrolyttemperatur ergänzt bzw. gestützt werden.

Vor jeder Umschaltung des Stellgliedes 15 wird der Gleichrichter 4 durch die Steuereinrichtung derart gesteuert, dass der Batteriestrom I_{B} zum Umschaltezeitpunkt möglichst gering ist, so dass das Stellglied lediglich zum Führen höherer Ströme, nicht jedoch zum Schalten höherer Ströme ausgelegt sein muss.

## Patentansprüche

1. Anordnung zur Überwachung einer aus mehreren in Reihe geschalteten Batterieuntereinheiten (7) bestehenden Batterie (8), die in einem Batteriezweig (6) parallel zu einem an einer steuerbaren Stromversorgungseinrichtung (2) angeschlossenen Verbraucher (1) liegt, mit einer den Batteriestrom (I_{B}) und die Spannung an der Batterie (8) oder die Spannungen an den Batterieuntereinheiten (7) erfassenden und daraus Informationen über den Funktionszustand der Batterie (8) bzw. den der Batterieuntereinheiten (7) ermittelnden Messeinrichtung (9), **gekennzeichnet durch** eine mit der Messeinrichtung (9) zusammenwirkende Steuereinrichtung (14), die zur Einstellung unterschiedlicher Betriebszustände der Batterie (8) die Stromversorgungseinrichtung (2) und ein in dem Batteriezweig (6) angeordnetes steuerbares Stellglied (15) steuert.

2. Anordnung nach Anspruch 1, **dadurch gekennze ichnet,** dass parallel zu dem Stellglied (15) eine Diode (16) geschaltet ist, deren Durchlassrichtung mit der Richtung des Entladestroms (I_{B-}) der Batterie (8) übereinstimmt.

3. Anordnung nach Anspruch 1 oder 2, **dadurch gekennzeichnet,** dass die Messeinrichtung (9) als Einrichtung zur Erfassung der Spannungen von Batterieuntereinheiten (7) bildenden Batteriezellen ausgebildet ist.

4. Anordnung nach Anspruch 1 oder 2, **dadurch geken-nzeichnet, dass** die Messeinrichtung (9) zur Erfassung der Spannungen an die Batterieunterheiten bildenden Blockbatterien ausgebildet ist.

5. Anordnung nach einem der vorangehenden Ansprüche, **dadurch gekennzeichnet, dass** bei einem Betriebszustand Erhaltungsladung" das Stellglied (15) geschlossen ist und bei in Laderichtung fließendem Batteriestrom (I_{B+}) die Spannung an der Batterie (8) bzw. den Batterieuntereinheiten (7) über die Zeit erfasst wird.

6. Anordnung nach einem der vorangehenden Ansprüche, **dadurch gekennzeichnet, dass** bei einem Betriebszustand Ruhephase" das Stellglied (15) geöffnet ist und die Messeinrichtung (9) aus der Ruhespannung an der Batterie (8) bzw. den Batterieunterheiten (7) die Säuredichte ermittelt.

7. Anordnung nach einem der vorangehenden Ansprüche, **dadurch gekennzeichnet, dass** bei einem Betriebszustand "Entladung" das Stellglied (15) geschlossen ist und die Ausgangsspannung der Stromversorgungseinrichtung (2) so weit herabgesetzt wird, dass der Batteriestrom (I_{B-}) in Entladungsrichtung fließt, und dass die Messeinrichtung (9) aus dem zeitlichen Verlauf der Spannung an der Batterie (8) bzw. den Batterieuntereinheiten (7) deren Restkapazität ermittelt.

8. Anordnung nach einem der vorangehenden Ansprüche, **dadurch gekennzeichnet, dass** bei einem Betriebszustand Stromsprung" das Stellglied (15) geschlossen ist, die Ausgangsspannung der Stromversorgungseinrichtung (2) so weit reduziert ist, dass der Batteriestrom (I_{B-}) in Entladungsrichtung fließt, und durch Änderung der Ausgangsspannung eine Änderung der Belastung der Batterie (8) hervorgerufen wird und dass die Messeinrichtung (9) aus dem zeitlichen Verlauf der Spannung an der Batterie (8) bzw. den Batterieuntereinheiten (7) deren Innenwiderstände ermittelt.

9. Anordnung nach einem der vorangehenden Ansprüche, **dadurch gekennzeichnet, dass** die Messeinrichtung (9) zur Erfassung der Elektrolyttemperatur in der Batterie (8) und zur Heranziehung der erfassten Elektrolyttemperatur bei der Ermittlung des Funktionszustandes der Batterie (8) bzw. der Batterieuntereinheiten (7) ausgebildet ist.

10. Anordnung nach einem der vorangehenden Ansprüche, **dadurch gekennzeichnet, dass** die Steuereinrichtung (14) vor einer Umschaltung des Stellgliedes (15) die Stromversorgungseinrichtung (2) zur Einstellung eines möglichst geringen Batteriestromes (I_{B}) steuert.

## Claims

1. Arrangement for monitoring a battery (8) which comprises two or more series-connected battery subunits (7) and is connected in a battery path (6) in parallel with a load (1) that is connected to a controllable power supply device (2), having a measurement device (9) which records the battery current (I_{B}) and the voltage across the battery (8) or the voltages across the battery subunits (7) and uses this to determine information about the functional state of the battery (8) or of the battery subunits (7), **characterized by** a control device (14) which interacts with the measurement device (9) and controls the power supply device (2) in order to set different operating states of the battery (8), and a controllable control element (15) which is arranged in the battery path (6).

2. Arrangement according to Claim 1, **characterized in that** a diode (16) whose forward-biased direction matches the direction of the discharge current (I_{B-}) of the battery (8) is connected in parallel with the control element (15).

3. Arrangement according to Claim 1 or 2, **characterized in that** the measurement device (9) is in the form of a device for recording the voltages of battery cells which form battery subunits (7).

4. Arrangement according to Claim 1 or 2, **characterized in that** the measurement device (9) is designed to record the voltages across block batteries which form the battery subunits.

5. Arrangement according to one of the preceding claims, **characterized in that** the control element (15) is closed in a "charge maintenance" operating mode, and, when the battery current (I_{B+}) is flowing in the charging direction, the voltage across the battery (8) or across the battery subunits (7) is recorded as a function of time.

6. Arrangement according to one of the preceding claims, **characterized in that** the control element (15) is open in a "rest phase" operating mode, and the measurement device (9) uses the no-load voltage across the battery (8) or across the battery subunits (7) to determine the acid density.

7. Arrangement according to one of the preceding claims, **characterized in that** the control element (15) is closed in a "discharge" operating mode, and the output voltage from the power supply device (2) is reduced such that the battery current (I_{B}-) flows in the discharge direction, and **in that** the measurement device (9) uses the time profile of the voltage across the battery (8) or the battery subunits (7) to determine its or their remaining capacity.

8. Arrangement according to one of the preceding claims, **characterized in that** the control element (15) is closed in a "sudden current change" operating mode, the output voltage of the power supply device (2) is reduced such that the battery current (I_{B-}) flows in the discharge direction, and a change in the load on the battery (8) is caused by changing the output voltage, and **in that** the measurement device (9) uses the time profile of the voltage across the battery (8) or the battery subunits (7) to determine its or their internal resistances.

9. Arrangement according to one of the preceding claims, **characterized in that** the measurement device (9) is designed to record the electrolyte temperature in the battery (8) and to use the recorded electrolyte temperature for determining the functional state of the battery (8) or of the battery subunits (7).

10. Arrangement according to one of the preceding claims, **characterized in that**, before switching of the control element (15), the control device (14) controls the power supply device (2) in order to set a battery current (I_{B}) which is as small as possible.

## Revendications

1. Dispositif de contrôle d'une batterie (8) qui est constituée de plusieurs sous-unités (7) de batterie montées en série et qui se trouve dans une branche (6) de la batterie en parallèle avec un appareil (1 ) consommateur raccordé à un dispositif (2) d'alimentation en courant qui peut être réglé, comprenant un dispositif (9) de mesure relevant le courant (I_{B}) de la batterie et la tension aux bornes de la batterie (8) ou les tensions aux bornes des sous-unités (7) de la batterie et en déterminant des informations sur l'état de fonctionnement de la batterie (8) ou sur celui des sous-unités (7) de la batterie, **caractérisé par** un dispositif (14) de réglage coopérant avec le dispositif (9) de mesure qui, pour établir des états de fonctionnement différents de la batterie (8), règle le dispositif (2) d'alimentation en courant et un composant (15) de réglage, qui peut être commandé et qui est monté dans la branche (6) de la batterie.

2. Dispositif suivant la revendication 1, **caractérisé en ce qu'**il est monté, en parallèle avec le composant (15) de réglage, une diode (16) dont le sens passant coïncide avec le sens du courant (Iₛ) de décharge de la batterie (8).

3. Dispositif suivant la revendication 1 ou 2, **caractérisé en ce que** le dispositif (9) de mesure est constitué en dispositif destiné à relever les tensions des éléments de la batterie formant les sous-unités (7) de la batterie.

4. Dispositif suivant la revendication 1 ou 2, **caractérisé en ce que** le dispositif (9) de mesure est constitué de manière à relever les tensions aux bornes des batteries monoblocs formant les sous-unités de la batterie.

5. Dispositif suivant l'une des revendications précédentes, **caractérisé en ce que** pour un état de fonctionnement "chargement de maintien", le composant (15) de réglage est fermé et pour un courant (I_{B+}) de batterie passant dans la direction de charge, la tension aux bornes à la batterie (8) ou aux bornes des sous-unités (7) de la batterie est relevée en fonction du temps.

6. Dispositif suivant l'une des revendications précédentes, **caractérisé en ce que** pour un état de fonctionnement "phase de repos", le composant (15) de réglage est ouvert et le dispositif (9) de mesure détermine, en fonction de la tension au repos aux bornes de la batterie (8) ou des sous-unités (7) de la batterie, l'étanchéité aux acides.

7. Dispositif suivant l'une des revendications précédentes, **caractérisé en ce que** pour un état de fonctionnement "décharge", le composant (15) de réglage est fermé et la tension de sortie du dispositif (2) d'alimentation en courant s'abaisse jusqu'à ce que le courant (I_{B+}) de la batterie passe dans le sens de la décharge et **en ce que** le dispositif (9) de mesure détermine, à partir de la courbe en fonction du temps de la tension aux bornes de la batterie (8) ou aux bornes des sous-unités (7) de la batterie, sa capacité restante.

8. Dispositif suivant l'une des revendications précédentes, **caractérisé en ce que** pour un état de fonctionnement "saut de courant", le composant (15) de réglage est fermé, la tension de sortie du dispositif (2) d'alimentation en courant est réduite jusqu'à ce que le courant (I_{B-}) de la batterie passe dans le sens de la décharge et, par une modification de la tension de sortie, il est provoqué une modification de la charge de la batterie (8) et **en ce que** le dispositif (9) de mesure détermine, à partir de la courbe en fonction du temps de la tension aux bornes de la batterie (8) ou aux bornes des sous-unités (7) de la batterie, leur résistance intérieure.

9. Dispositif suivant l'une des revendications précédentes, **caractérisé en ce que** le dispositif (9) de mesure est constitué pour relever la température de l'électrolyte dans la batterie (8) et pour tirer parti de la température d'électrolyte qui est relevée lors de la détermination de l'état de fonctionnement de la batterie (8) ou des sous-unités (7) de la batterie.

10. Dispositif suivant l'une des revendications précédentes, **caractérisé en ce que** le dispositif (14) de commande commande avant une commutation du composant (15) de réglage, le dispositif (2) d'alimentation en courant, pour établir un courant (I_{B}) de la batterie aussi peu intense que possible.
